# EUROPEAN PATENT APPLICATION

(11) **EP 2 530 708 A1**
(43) Date of publication of application: **05.12.2012**
(21) Application number: 11734655.1
(22) Date of filing: 19.01.2011
(51) Int. Cl.: H01L 21/60, H01L 21/607, H05K 3/32

(54) **FLIP-CHIP MOUNTING STRUCTURE AND FLIP-CHIP MOUNTING METHOD**

(30) Priority: 25.01.2010 JP 2010013411
(71) Applicant: Japan Aviation Electronics Industry, Limited, Tokyo 150-0043 (JP)
(72) Inventor: UCHIDA, Daisuke, Tokyo 150-0043 (JP)
(74) Representative: Erny, Tobias
(86) International application number: PCT/JP2011/050817
(87) International publication number: WO 2011/090049

(57) **Abstract**

When a flip-chip mounting component with an Al/Au bonding structure is exposed to high temperature, voids may be caused in the Al electrode. The generation of voids causes failed connection or failed bonding between the Al electrode and the Au bump, thereby significantly degrading the connection reliability and bonding reliability in the flip-chip mounting structure. An object of the preset invention is to provide a flip-chip mounting structure that has high connection reliability and bonding reliability without being degraded even in high temperature. In a flip-chip mounting structure for wirelessly connecting an IC chip 21 having an Al electrode 22 and a substrate 41 having an Au electrode 43, a bump 52 of Al or Al alloy is formed on the Al electrode 22 of the IC chip 21 and, via the bump 52, the Al electrode 22 of the IC chip 21 and the Au electrode 43 of the substrate 41 are bonded to each other.

## Description

### TECHNICAL FIELD

The present invention relates to a flip-chip mounting structure and a flip-chip mounting method of an integrated circuit (IC) chip.

### BACKGROUND ART

In flip-chip mounting of an IC chip, generally, a bump is formed on an electrode of the IC chip and the bump is directly bonded to an electrode on a corresponding substrate (mounting substrate). Generally, the bump is formed by ball bonding in which a tip of a metal wire is melted to form a ball and the ball is secured to the electrode of the IC chip by thermocompression bonding etc.

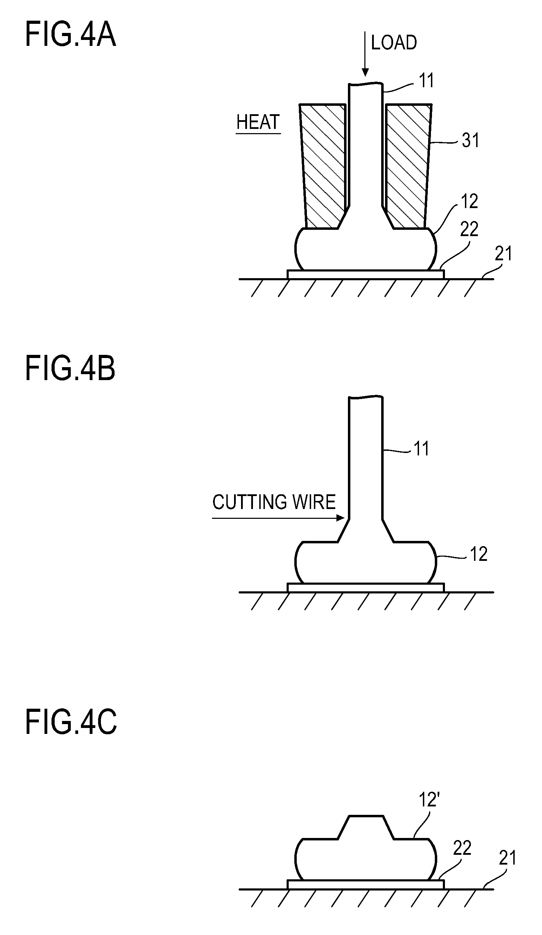

Figs. 4A to 4C show a method of forming a bump by such ball bonding. Fig. 4A shows the state in which a ball 12 formed by the melting of a tip of a metal wire 11 is secured to an electrode 22 of an IC chip 21 by thermocompression bonding. The ball 12 is loaded by a ball bonding capillary 31, subjected to thermocompression bonding, and deformed as shown in Fig. 4A.

The metal wire 11 is cut as shown in Fig. 4B to remove excess parts of the wire 11. A bump 12' is formed on the electrode 22 of the IC chip 21 as shown in Fig. 4C.

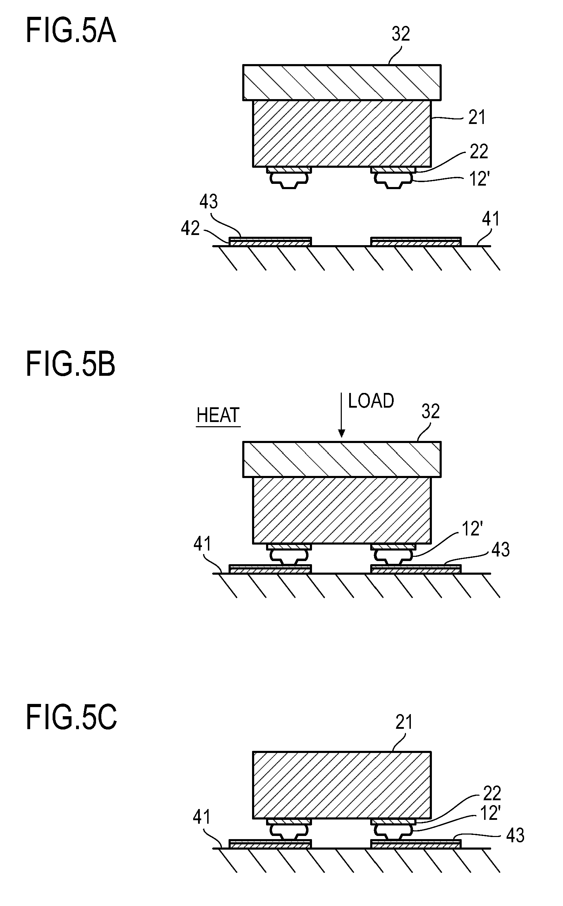

Figs. 5A to 5C show flip-chip mounting of the IC chip 21 on which the bump 12' is formed as described above, on the substrate 41. As shown in Fig. 5A, the IC chip 21 is secured to and held by a flip-chip bonding tool 32.

The Cu electrode 42 of the substrate 41 on which the IC chip 21 is flip-chip-mounted includes Cu (copper) and, in this example, the Cu electrode 42 is coated with Au (gold) to form an Au electrode 43.

Fig. 5B shows the state in which the flip-chip bonding tool 32 moves (for example, goes down) and the bump 12' is aligned with and brought into contact with the Au electrode 43 of the substrate 41. If, for example, heat and load is applied in the state shown in Fig. 5B, the bump 12' and the Au electrode 43 are bonded to each other. Then, the flip-chip bonding tool 32 is removed to complete the flip-chip mounting. The completed flip-chip mounting structure is shown in Fig. 5C. The bonding between the bump 12' and the Au electrode 43 is not limited to thermocompression bonding; for example, ultrasonic bonding, in which ultrasonic vibration is applied under a load, may be used.

In the flip-chip mounting structure described above, an Al (aluminum) electrode is generally used as the Al electrode 22 of the IC chip 21. An Au wire, which is appropriate for ball bonding, is generally used as the metal wire 11 from which the ball 12 is formed (see patent literature 1, for example).

### PRIOR ART LITERATURE

### PATENT LITERATURE

Patent literature 1: Japanese Patent Application Laid Open No. 2002-368039

### SUMMARY OF THE INVENTION

### PROBLEMS TO BE SOLVED BY THE INVENTION

Since an Au bump is formed on the Al electrode of an IC chip in the conventional flip-chip mounting structure of the IC chip as described above, an Al/Au bonding structure is present.

If a flip-chip mounting component with this type of Al/Au bonding structure is exposed to high temperature, mutual diffusion between Al and Au is promoted. This causes all Al, which is less than Au in amount, to diffuse into Au, possibly generating voids in the Al electrode. The generation of voids causes failed connection or failed bonding between the Al electrode and the Au bump. This significantly degrades the connection reliability and bonding reliability of the flip-chip mounting structure.

The present invention addresses this problem with the object of providing a flip-chip mounting structure and a flip-chip mounting method that can obtain high connection reliability and bonding reliability even in high temperature.

### MEANS TO SOLVE THE PROBLEMS

According to a first aspect of the present invention, a flip-chip mounting structure for wireless connection has an integrated circuit chip having an aluminum electrode and a substrate having a gold electrode, in which the aluminum electrode of the integrated circuit chip and the gold electrode of the substrate are bonded to each other via a bump of aluminum or aluminum alloy formed on the aluminum electrode of the integrated circuit chip.

According to a second aspect of the present invention, a flip-chip method for wirelessly connecting an integrated circuit chip having an aluminum electrode and a substrate having a gold electrode to each other, includes the step of performing wedge bonding of a wire made of aluminum or aluminum alloy on the aluminum electrode of the integrated circuit chip by adding supersonic vibration with a wedge bonding capillary, the step of forming a bump by cutting and removing an excess part of the wire subjected to wedge bonding, and the step of aligning the aluminum electrode of the integrated circuit chip on which the bump has been formed with the gold electrode of the substrate, applying pressure, and adding supersonic vibration to bond the aluminum electrode and the gold electrode together.

### EFFECTS OF THE INVENTION

According to the present invention, the amount of Al can be increased in the flip-chip mounting with the Al/Au bonding structure. Accordingly, one-sided diffusion of Al into Au is not caused, thereby suppressing the generation of voids in the Al electrode of an IC chip, which occurred conventionally. This achieves the high connection reliability and bonding reliability even in high temperature. In other words, it is possible to obtain a superior flip-chip mounting structure with a tolerance against vibration and impact that does not degrade even in exposure to high temperature for extended period of time.

### BRIEF DESCRIPTION OF THE DRAWINGS

Fig. 1A shows the state in which a tip of an Al wire 51 is positioned on the Al electrode 22 of the IC chip 21;
Fig. 1B shows the state in which the Al wire 51 is cut;
Fig. 1C shows the state in which an Al bump 52 is formed on the Al electrode 22.
Fig. 2A shows the state in which the IC chip 21 is secured to the flip-chip banding tool 32;
Fig. 2B shows the state in which the Al bump 52 is aligned with and brought into contact with the Au electrode 43 of the substrate 41;
Fig. 2C shows the state in which flip-chip mounting is completed.
Fig. 3 is a flowchart showing a process according to an embodiment.
Fig. 4A shows the state in which the ball 12 formed by the melting of a tip of the metal wire 11 is secured to the electrode 22 of the IC chip 21 by thermocompression bonding;
Fig. 4B shows the state in which the metal wire 11 is cut;
Fig. 4C shows the state in which the bump 12' is formed on the electrode 22 of the IC chip 21;
Fig. 5A shows the state in which the IC chip 21 is secured to and held by the flip-chip bonding tool 32;
Fig. 5B shows the state in which the bump 12' is aligned with and brought into contact with the Au electrode 43 of the substrate 41;
Fig. 5C shows the state in which a flip-chip mounting structure is completed.

### DETAILED DESCRIPTION OF THE EMBODIMENTS

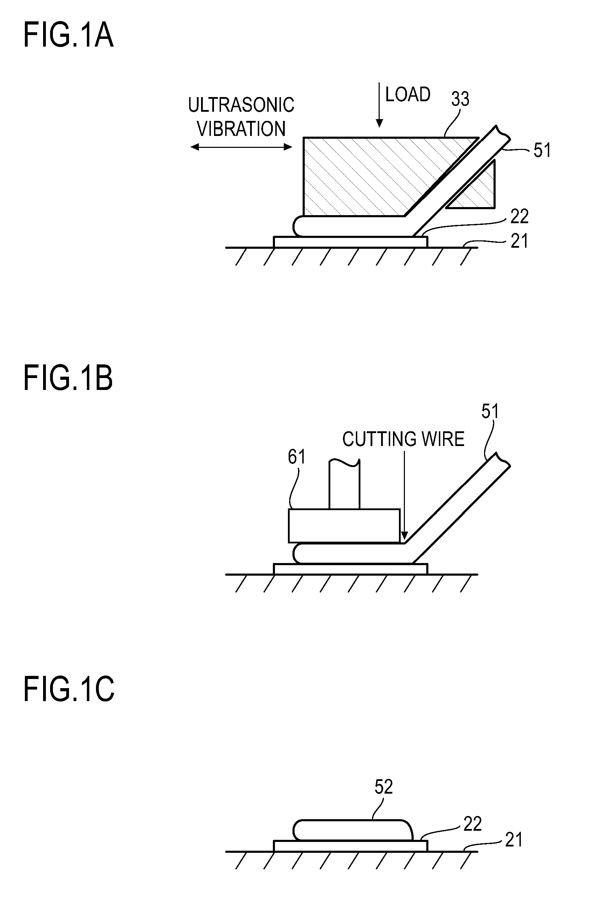

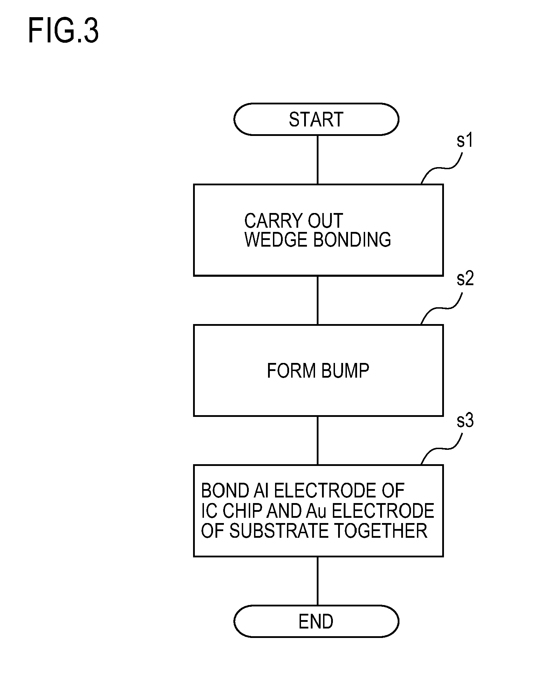

An embodiment of the present invention will be described with reference to Figs. 1 to 3.

In this example, the bump formed on the Al electrode of the IC chip is an Al bump, not an Au bump. Wedge bonding is used to form an Al bump because ball bonding, which is used to form Au bumps, is not appropriate for the forming of an Al bump. There are the two following reasons why ball bonding is not appropriate for the forming of an Al bump. The first reason is that the height of a tip of an Al bump tends to become uneven when the Al bump is formed by ball bonding since Al is harder than Au. The second reason is that Al undergoes oxidation in ball bonding, which forms balls by thermal melting, since Al easily undergoes thermal oxidation. Any of these can cause a serious failure.

Figs. 1A to 1C show the method of forming an Al bump by wedge bonding. Fig. 1A shows the state in which the tip of the Al wire 51 is positioned on the Al electrode 22 of the IC chip 21. The Al wire 51 is secured to the Al electrode 22 by applying a load to the Al wire 51 with a wedge bonding capillary 33 and adding supersonic vibration (s1).

The Al wire 51 is cut as shown in Fig. 1B. The Al wire 51 is cut by, for example, holding the Al wire 51 with a clamp 61 and pulling the Al wire 51. This cuts and removes the excess part of the Al wire 51 (s2). The Al bump 52 is formed on the Al electrode 22 as shown in Fig. 1C.

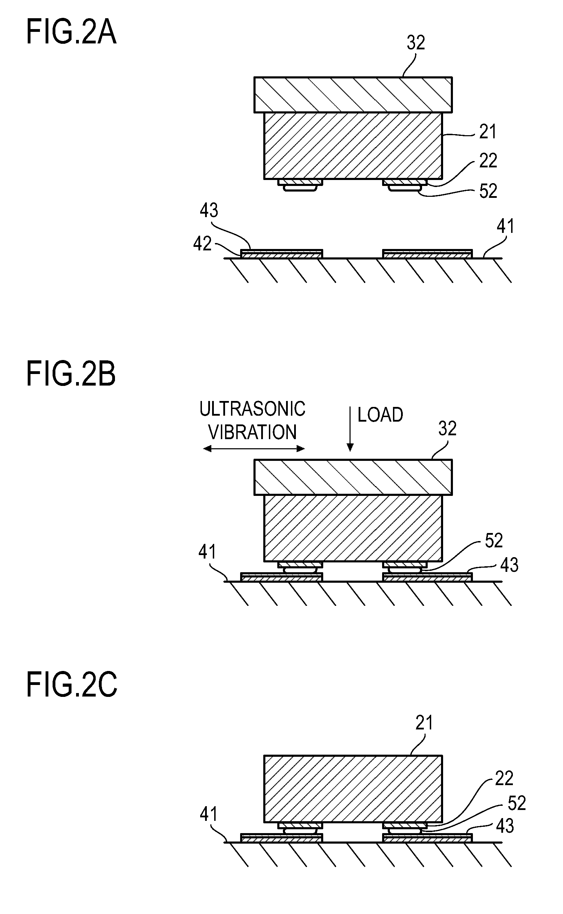

Figs. 2A to 2C show the method for flip-chip mounting of the IC chip 21 on which the Al bump 52 was formed, onto the substrate 41. The IC chip 21 is secured to the flip-chip bonding tool 32 as shown in Fig. 2A and then the flip-chip mounting is performed.

Fig. 2B shows the state in which the flip-chip bonding tool 32 moves (for example, goes down) and the Al bump 52 is aligned with and brought into contact with the Au electrode 43 of the substrate 41. In the state shown in Fig. 2B, the flip-chip bonding tool 32 applies a load and adds supersonic vibration to the Al bump 52 and the Au electrode 43 to bond the Al bump 52 and the Au electrode 43 together. Fig. 2C shows the state in which the flip-chip bonding tool 32 is removed and the flip-chip mounting is completed.

In this example, the Al bump 52 is formed on the Al electrode 22 of the IC chip 21 and the Al electrode 22 of the IC chip 21 is bonded to the Au electrode 43 of the substrate 41 via the Al bump 52 as shown (s3). Accordingly, the amount of Al can be increased greatly in the flip-chip mounting with the Al/Au bonding structure.

In this example, one-sided diffusion of Al into Au is not caused, thereby suppressing the generation of voids in the Al electrode 22, which occurred conventionally. This achieves high connection reliability and bonding reliability even in high temperature. More specifically, it is possible to achieve a bonding strength in which a tolerance against vibration and impact can be maintained without being degraded even in exposure to high temperature of two hundreds and several tens of degrees Celsius for thousands of hours. This enables the flip-chip mounting of the IC chip 21 assumed to be used in such high temperature and contributes to the downsizing of the substrate (mounting substrate) 41.

The size of the Al bump 52 is exemplified by a length in the electrode surface direction of not greater than approximately 100 µm and a thickness of approximately 5 to 50 µm.

In the above example, the wire used to form the Al bump 52 is the Al wire 51, but it may be a wire made of Al alloy. That is, the Al bump 52 may be an Al alloy bump.

In addition, the wedge bonding capillary 33 may be any form of tool that can carry out wedge bonding properly.

The present invention is not limited to the above embodiment and may be modified as appropriate without departing from the scope of the invention.

### DESCRIPTION OF REFERENCE NUMERALS

- 11: Metal wire
- 12: Ball
- 12': Bump
- 21: IC chip
- 22: Al electrode
- 31: Ball bonding capillary
- 32: Flip-chip bonding tool
- 33: Wedge bonding capillary
- 41: Substrate
- 42: Cu electrode
- 43: Au electrode
- 51: Al wire
- 52: Al bump

## Claims

1. A flip-chip mounting structure for wireless connection, comprising:
an integrated circuit chip having an aluminum electrode; and
a substrate having a gold electrode;
wherein the aluminum electrode of the integrated circuit chip and the gold electrode of the substrate are bonded to each other via a bump of aluminum or aluminum alloy formed on the aluminum electrode of the integrated circuit chip.

2. A flip-chip mounting method for wirelessly connecting an integrated circuit chip having an aluminum electrode and a substrate having a gold electrode to each other, the method comprising the steps of:
performing wedge bonding of a wire made of aluminum or aluminum alloy on the aluminum electrode of the integrated circuit chip by adding supersonic vibration with a wedge bonding capillary;
forming a bump by cutting and removing an excess part of the wire subjected to wedge bonding; and
aligning the aluminum electrode of the integrated circuit chip on which the bump has been formed with the gold electrode of the substrate, applying pressure, and adding supersonic vibration to bond the aluminum electrode and the gold electrode together.
